# EUROPEAN PATENT APPLICATION

(11) **EP 4 642 194 A1**
(43) Date of publication of application: **29.10.2025**
(21) Application number: 25171236.0
(22) Date of filing: 17.04.2025
(51) Int. Cl.: H10H 20/831, H10H 20/832

(54) **LIGHT-EMITTING ELEMENT**

(30) Priority: 25.04.2024 JP 2024071231; 24.12.2024 JP 2024227457
(71) Applicant: NICHIA CORPORATION, Anan-shi, Tokushima 774-8601 (JP)
(72) Inventor: SUNDA, Takamasa, Anan-shi, Tokushima, 774-8601 (JP)
(74) Representative: Betten & Resch

(57) **Abstract**

A light-emitting element includes: a semiconductor structure including: an n-side semiconductor layer, an active layer disposed on the n-side semiconductor layer, and a p-side semiconductor layer disposed on the active layer, wherein: a first opening extends through the active layer and the p-side semiconductor, and the n-side semiconductor layer is exposed from the active layer and the p-side semiconductor layer by the first opening; a first insulating film disposed on the semiconductor structure, wherein a second opening extends through the first insulating film at a position overlapping the first opening in a plan view; and n-side wiring including: a first metal layer contacting the n-side semiconductor layer via the second opening, a second metal layer disposed on the first metal layer, and a third metal layer disposed on the second metal layer.

## Description

### TECHNICAL FIELD

The present disclosure relates to a light-emitting element.

### BACKGROUND

Japanese Patent Publication No. 2023-63468 discloses a light-emitting element in which some semiconductor layers of a semiconductor structure are provided with an opening and wiring is in contact with a semiconductor layer exposed through the opening.

In a case where the wiring of the light-emitting element includes a plurality of metal layers, the light reflectance of the wiring may be reduced in the opening of the semiconductor structure.

### SUMMARY

An object of one embodiment of the present disclosure is to provide a light-emitting element that can reduce a decrease in light reflectance of wiring of the light-emitting element.

According to an embodiment of the present disclosure, a light-emitting element includes: a semiconductor structure having a first opening and including an n-side semiconductor layer, an active layer disposed on the n-side semiconductor layer, and a p-side semiconductor layer disposed on the active layer, the first opening being provided in the active layer and in the p-side semiconductor and exposing the n-side semiconductor layer through the active layer and the p-side semiconductor layer; a first insulating film disposed on the semiconductor structure and having a second opening at a position overlapping the first opening in a plan view; and n-side wiring including a first metal layer contacting the n-side semiconductor layer in the second opening, a second metal layer disposed on the first metal layer, and a third metal layer disposed over the second metal layer. A light reflectance of the first metal layer with respect to a peak wavelength of light emitted from the active layer is higher than a light reflectance of the third metal layer with respect to the peak wavelength of the light emitted from the active layer. The first metal layer has a crystal structure same as a crystal structure of the third metal layer. The second metal layer has a crystal structure different from the crystal structure of the first metal layer and the crystal structure of the third metal layer. The third metal layer does not overlap the first opening in the plan view.

According to an embodiment of the present disclosure, a light-emitting element includes: a semiconductor structure having a first opening and including an n-side semiconductor layer, an active layer disposed on the n-side semiconductor layer, and a p-side semiconductor layer disposed on the active layer, the first opening being provided in the active layer and in the p-side semiconductor and exposing the n-side semiconductor layer through the active layer and the p-side semiconductor layer; a first insulating film disposed on the semiconductor structure and having a second opening at a position overlapping the first opening in a plan view; and n-side wiring including a first metal layer contacting the n-side semiconductor layer in the second opening, a second metal layer disposed on the first metal layer, and a third metal layer disposed over the second metal layer. The first metal layer contains a metal element selected from at least one of Al or Ag. The second metal layer contains a metal element selected from at least one of Ti, Ta, W, Mo, Nb, Cr, Zr, Hf, or Re. The third metal layer contains a metal element selected from at least one of Au or Cu. The third metal layer does not overlap the first opening in the plan view.

### BRIEF DESCRIPTION OF THE DRAWINGS

FIG. 1 is a plan view of a light-emitting element according to a first embodiment;
FIG. 2 is a cross-sectional view taken along A-A of FIG. 1;
FIG. 3 is a cross-sectional view taken along B-B of FIG. 1;
FIG. 4 is a cross-sectional view taken along C-C of FIG. 1;
FIG. 5 is an enlarged plan view of a first opening 12A and a second opening 30A according to the first embodiment;
FIG. 6 is an enlarged cross-sectional view of the first opening 12A and the second opening 30A according to the first embodiment;
FIG. 7 is an enlarged cross-sectional view of a first opening 12A and a second opening 30A in a comparative structure;
FIG. 8 is an enlarged plan view of an outer peripheral region 12B and a fourth opening 30B according to the first embodiment; and
FIG. 9 is an enlarged cross-sectional view of a third opening 34A according to the first embodiment.

### DETAILED DESCRIPTION

Embodiments of the present disclosure will be described in detail below with reference to the drawings. The following description is provided for the purpose of embodying the technical ideas of the present invention, but the present invention is not limited to the described configurations and numerical values. In the drawings, components having the same functions may be denoted by the same reference numerals, and a duplicate description thereof may be omitted as appropriate. The sizes, positional relationships, and the like of members illustrated in the drawings may be exaggerated to facilitate understanding of the present disclosure.

### (First Embodiment)

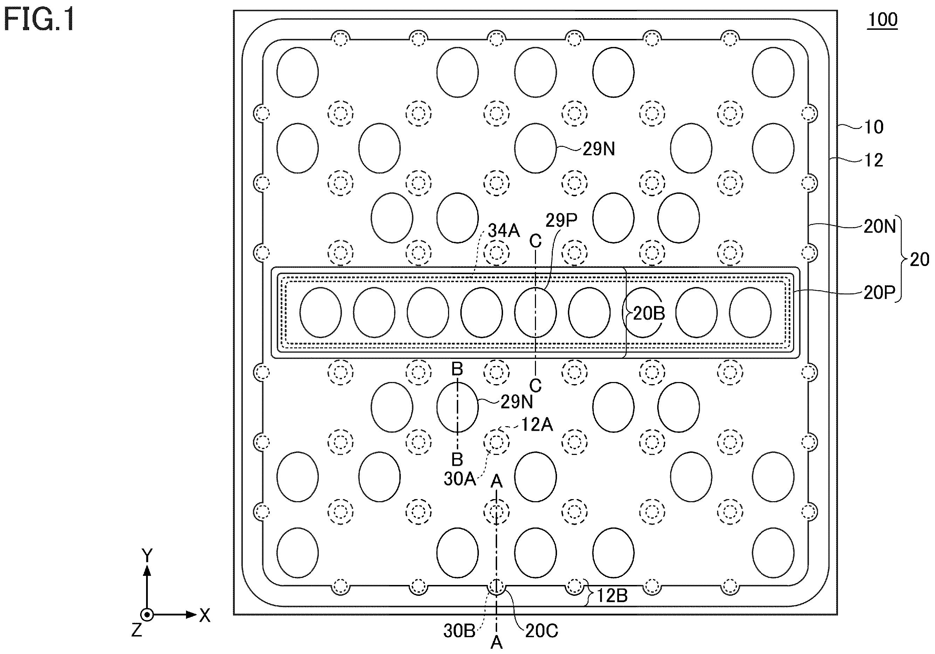

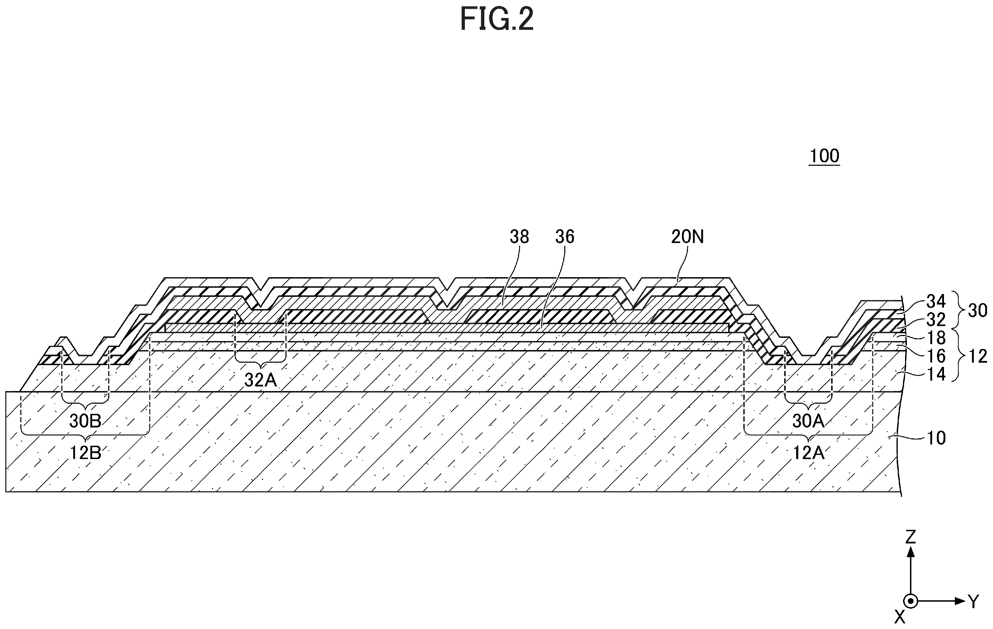

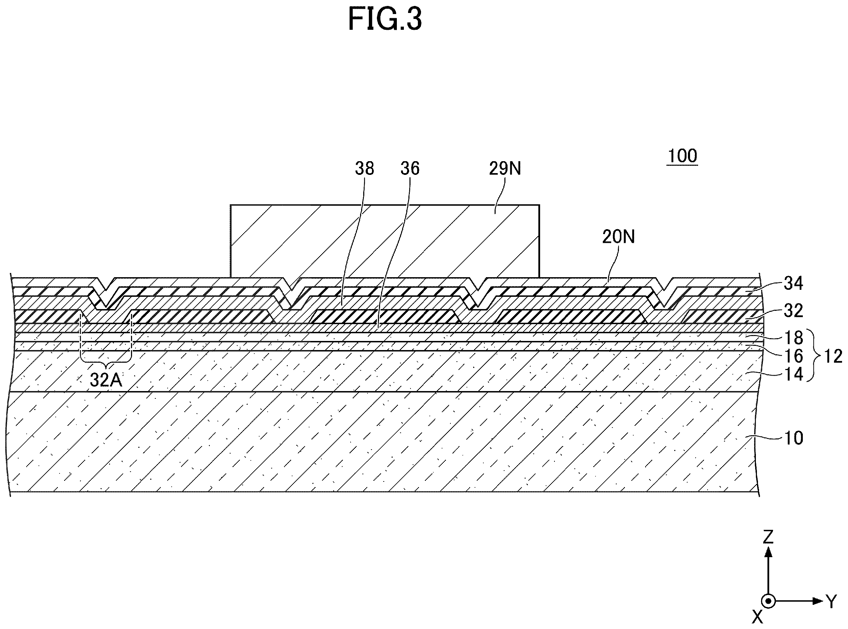

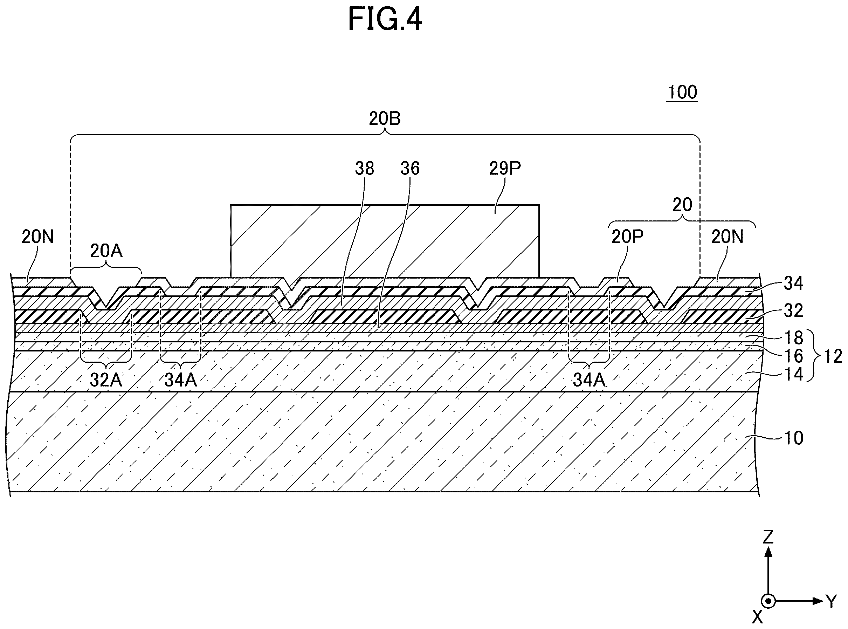

FIG. 1 is a plan view of a light-emitting element according to a first embodiment. FIG. 2 is a cross-sectional view taken along A-A of FIG. 1. FIG. 3 is a cross-sectional view taken along B-B of FIG. 1. FIG. 4 is a cross-sectional view taken along C-C of FIG. 1. FIG. 1 illustrates a substrate 10, a semiconductor structure 12, wiring 20, an n-side electrode 29N, a p-side electrode 29P, an opening 20B, a second opening 30A, a fourth opening 30B, and a third opening 34A. A thickness direction of the substrate 10 is defined as a Z direction, an extending direction of p-side wiring 20P is defined as an X direction, and a direction orthogonal to the X direction and the Z direction is defined as a Y direction. A viewpoint viewed in the Z direction is also referred to as a plan view.

As illustrated in FIG. 1, in a light-emitting element 100 according to the first embodiment, the semiconductor structure 12 is disposed on the substrate 10. N-side wiring 20N and the p-side wiring 20P are disposed as the wiring 20 on the semiconductor structure 12. The n-side wiring 20N has a protruding portion 20C whose outer edge protrudes outward in a plan view. In the example illustrated in FIG. 1, the shape of the protruding portion 20C in a plan view is a substantially semicircular shape. The n-side wiring 20N has the opening 20B. In the example illustrated in FIG. 1, the shape of the opening 20B in a plan view is a substantially rectangular shape with a longer side in the X direction and a shorter side in the Y direction. The p-side wiring 20P is disposed in the opening 20B in a plan view. The n-side wiring 20N and the p-side wiring 20P are electrically separated. In the example illustrated in FIG. 1, the shape of the p-side wiring 20P in a plan view is a substantially rectangular shape with a longer side in the X direction and a shorter side in the Y direction.

A first opening 12A of the semiconductor structure 12, the second opening 30A of a first insulating film 30, and the fourth opening 30B of the first insulating film 30 are located so as to overlap the n-side wiring 20N in a plan view. The first insulating film 30 and the semiconductor structure 12 will be described later. In a plan view, the first opening 12A and the second opening 30A are disposed inward of an outer peripheral region 12B described later. The fourth opening 30B is disposed so as to overlap the protruding portion 20C of the n-side wiring 20N in a plan view. The second opening 30A is disposed so as to overlap the first opening 12A in a plan view. The shape of each of the first opening 12A, the second opening 30A, and the fourth opening 30B in a plan view is, for example, a circular shape. The third opening 34A is provided so as to overlap the p-side wiring 20P in a plan view. For example, the shape of the third opening 34A in a plan view is a substantially rectangular shape with a longer side in the X direction and a shorter side in the Y direction.

As illustrated in FIG. 1 and FIG. 3, the n-side electrode 29N may be disposed on the n-side wiring 20N. Further, the p-side electrode 29P may be disposed on the p-side wiring 20P. For example, the shape of each of the n-side electrode 29N and the p-side electrode 29P in a plan view is an elliptical shape or a circular shape. The shapes of the n-side wiring 20N, the p-side wiring 20P, the opening 20B, the protruding portion 20C, the second opening 30A, the fourth opening 30B, the third opening 34A, the n-side electrode 29N, and the p-side electrode 29P in a plane view can be any shapes other than the above-described shapes as appropriate.

As illustrated in FIG. 2 to FIG. 4, the semiconductor structure 12 is provided on the substrate 10. The substrate 10 is, for example, a sapphire substrate, a spinel substrate, a gallium nitride (GaN) substrate, a silicon carbide (SiC) substrate, a zinc sulfide (ZnS) substrate, a zinc oxide (ZnO) substrate, a gallium arsenide (GaAs) substrate, or a silicon (Si) substrate. The shape of the substrate 10 in a plan view is, for example, a rectangular shape. When the shape of the substrate 10 in a plan view is a rectangular shape, the length of one side of the rectangular shape is, for example, 100 µm or more and 2,000 µm or less. Each layer of the semiconductor structure 12 is, for example, a nitride semiconductor layer. The nitride semiconductor layer is, for example, InₓAl_{y}Ga_{1-x-y}N (0 ≤ x ≤ 1, 0 ≤ y ≤ 1, x + y ≤ 1).

The semiconductor structure 12 includes an n-side semiconductor layer 14, an active layer 16, and a p-side semiconductor layer 18. The n-side semiconductor layer 14 is disposed on the substrate 10. The active layer 16 is disposed on the n-side semiconductor layer 14. The p-side semiconductor layer 18 is disposed on the active layer 16. The n-side semiconductor layer 14 is an n-type semiconductor layer containing an n-type impurity. The p-side semiconductor layer 18 is a p-type semiconductor layer containing a p-type impurity. The active layer 16 has, for example, a multi-quantum well (MQW) structure in which a plurality of barrier layers and a plurality of well layers are alternately layered.

As illustrated in FIG. 2, the semiconductor structure 12 has the first opening 12A and the outer peripheral region 12B. The first opening 12A is provided in the active layer 16 and in the p-side semiconductor layer 18 and exposes the n-side semiconductor layer 14 through the active layer 16 and the p-side semiconductor layer 18. Further, the first opening 12A is surrounded by the active layer 16 and the p-side semiconductor layer 18 in a plan view. The outer peripheral region 12B is a region that is located on an outer peripheral portion of the semiconductor structure 12 and in which the n-side semiconductor layer 14 is exposed through the active layer 16 and the p-side semiconductor layer 18. The outer peripheral region 12B surrounds the active layer 16 and the p-side semiconductor layer 18 in a plan view.

As illustrated in FIG. 2 to FIG. 4, a first conductor layer 36 is disposed on the p-side semiconductor layer 18. The first conductor layer 36 is electrically connected to the p-side semiconductor layer 18. A first layer 32 is provided on the first conductor layer 36. The first layer 32 has an opening 32A that overlaps the first conductor layer 36 in a plan view. A second conductor layer 38 is disposed on the first layer 32. The second conductor layer 38 is electrically connected to the first conductor layer 36 via the opening 32A. A second layer 34 is provided on the second conductor layer 38. As illustrated in FIG. 4, the second layer 34 has the third opening 34A.

The wiring 20 is disposed on the second layer 34. In the present embodiment, the second layer may also be referred to as a second insulating film. The wiring 20 includes the n-side wiring 20N and the p-side wiring 20P. As illustrated in FIG. 4, the wiring 20 has an opening 20A, and the n-side wiring 20N and the p-side wiring 20P are electrically separated by the opening 20A. The p-side wiring 20P is electrically connected to the second conductor layer 38 via the third opening 34A. As illustrated in FIG. 3 and FIG. 4, the n-side electrode 29N is disposed on the n-side wiring 20N, and the p-side electrode 29P is disposed on the p-side wiring 20P. The n-side electrode 29N is electrically connected to the n-side wiring 20N, and the p-side electrode 29P is electrically connected to the p-side wiring 20P.

As illustrated in FIG. 2, the first layer 32 and the second layer 34 cover lateral surfaces of the semiconductor structure 12 in the first opening 12A and the outer peripheral region 12B. In the present embodiment, the first insulating film 30 includes the first layer 32 and the second layer 34. The first insulating film 30 has the second opening 30A at a position overlapping the first opening 12A in a plan view, and has the fourth opening 30B at a position overlapping the outer peripheral region 12B in a plan view. The n-side wiring 20N is electrically connected to the n-side semiconductor layer 14 via the first opening 12A and the second opening 30A.

As described above, the n-side electrode 29N is electrically connected to the n-side semiconductor layer 14 via the n-side wiring 20N. The p-side electrode 29P is electrically connected to the p-side semiconductor layer 18 via the p-side wiring 20P, the second conductor layer 38, and the first conductor layer 36.

The first layer 32 is a film containing, for example, silicon oxide or silicon nitride as a main component, and may be a single layer film or a multilayer film in which a plurality of insulating films are layered. The first layer 32 may function to reflect light emitted from the active layer 16. When the first layer 32 functions to reflect light emitted from the active layer 16, the first layer 32 preferably has a light reflectance of 80% or more with respect to the peak wavelength of the light emitted from the active layer 16. The first conductor layer 36 is a transmissive conductor such as indium tin oxide (ITO), zinc oxide (ZnO), or indium oxide (In₂O₃). The first conductor layer 36 diffuses the current in a planar direction and reduces uneven light distribution.

The second layer 34 is, for example, a silicon oxide film or a silicon nitride film, and may be a single layer film or a multilayer film in which a plurality of insulating films are layered. The second conductor layer 38 is a metal layer containing, for example, silver or aluminum as a main component. The configuration of the wiring 20 will be described later. The n-side electrode 29N and the p-side electrode 29P are metal layers respectively containing gold (Au), silver (Ag), copper (Cu), aluminum (Al), platinum (Pt), or an alloy thereof as a main component.

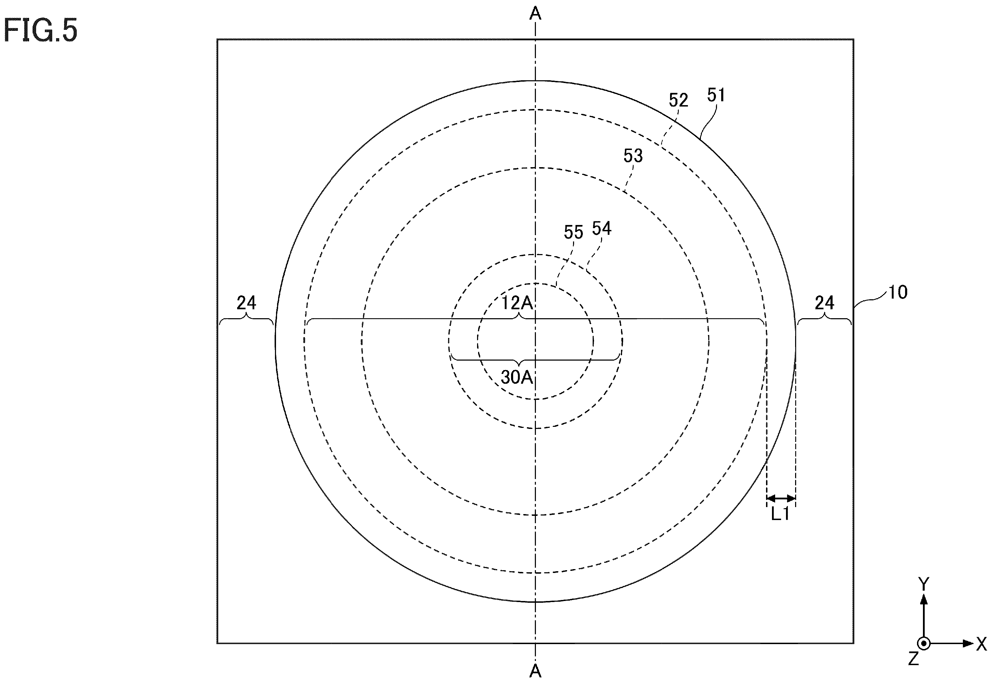

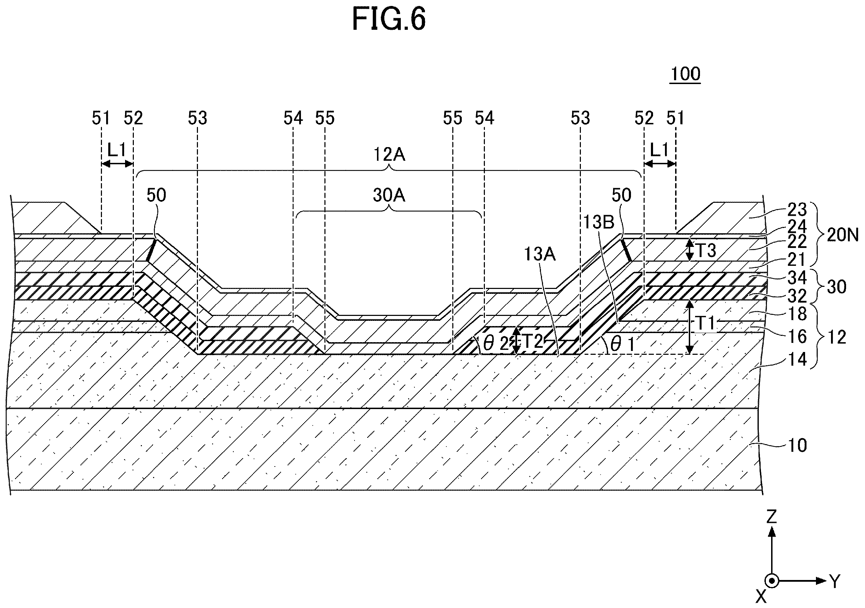

FIG. 5 is an enlarged plan view of the first opening 12A and the second opening 30A according to the first embodiment. FIG. 6 is an enlarged cross-sectional view of the first opening 12A and the second opening 30A according to the first embodiment, and is a cross-sectional view taken along A-A of FIG. 5. As illustrated in FIG. 6, the first opening 12A is defined by a first surface 13A of the semiconductor structure 12 and a second surface 13B of the semiconductor structure 12. The first surface 13A is defined by a portion of the surface (the upper surface in FIG. 6) of the n-side semiconductor layer 14. The second surface 13B is defined by a portion of a lateral surface of the n-side semiconductor layer 14, a portion of a lateral surface of the active layer 16, and a portion of a lateral surface of the p-side semiconductor layer 18, and is connected to the first surface 13A. The inclination angle of the second surface 13B relative to the first surface 13A is defined as θ1. The second opening 30A is defined by a portion of a lateral surface of the first insulating film 30. In the present embodiment, as illustrated in FIG. 5 and FIG. 6, the n-side wiring 20N includes a first metal layer 21, a second metal layer 22, and a third metal layer 23. The n-side wiring 20N may further include a fourth metal layer 24. The first metal layer 21 is disposed on the first insulating film 30 and the n-side semiconductor layer 14, and is electrically connected to the n-side semiconductor layer 14. The second metal layer 22 is disposed on the first metal layer 21. The fourth metal layer 24 is disposed on the second metal layer 22. The third metal layer 23 is disposed on the fourth metal layer 24. The third metal layer 23 is not disposed in the first opening 12A.

In the present embodiment, a lower end 51 (an end on the -Z side) of a lateral surface of the third metal layer 23, an upper end 52 (an end on the +Z side) of the second surface 13B, a lower end 53 of the second surface 13B, an upper end 54 of the lateral surface of the first insulating film 30 defining the second opening 30A, and a lower end 55 of the lateral surface of the first insulating film 30 defining the second opening 30A are concentrically arranged. The shape of each of the lower end 51 of the lateral surface of the third metal layer 23, the upper end 52 of the second surface 13B, the lower end 53 of the second surface 13B, the upper end 54 of the lateral surface of the first insulating film 30 defining the second opening 30A, and the lower end 55 of the lateral surface of the first insulating film 30 defining the second opening 30A in a plan view may be a circular shape, may be an elliptical shape or a polygonal shape, or may be appropriately set.

The inclination angle of the lateral surface of the first insulating film 30 relative to the first surface 13A is defined as θ2. The distance between the first surface 13A and the surface of the p-side semiconductor layer 18 in the Z direction is defined as T1. The thickness of the first insulating film 30 located inside the first opening 12A is defined as T2. The thickness of the second metal layer 22 located outside the first opening 12A is defined as T3. The distance from the first opening 12A to the third metal layer 23 is defined as L1.

The first metal layer 21 is a layer electrically connected to the n-side semiconductor layer 14 and functions to reflect light emitted from the active layer 16. The third metal layer 23 is a layer having a low electrical resistance and diffuses the current in a planar direction as will be described later.

In heat treatment in a process of manufacturing the light-emitting element, there may be a case where a metal element of the first metal layer 21 and a metal element of the third metal layer 23 interdiffuse. If interdiffusion occurs, the light reflectance of the first metal layer 21 would be decreased, and the resistivity of the third metal layer 23 would be increased. By providing the second metal layer 22, interdiffusion between the first metal layer 21 and the third metal layer 23 can be reduced. It is preferable that the fourth metal layer 24, functioning to reduce corrosion of the second metal layer 22 and the third metal layer 23, is disposed between the second metal layer 22 and the third metal layer 23. The fourth metal layer 24 is not necessarily provided.

The light reflectance of the first metal layer 21 with respect to the peak wavelength of light emitted from the active layer 16 is higher than the light reflectance of the third metal layer 23 with respect to the peak wavelength of the light emitted from the active layer 16. Thus, the first metal layer 21 functions as a layer that reflects light.

Metals having the same crystal structure tend to easily interdiffuse. The first metal layer 21 has a crystal structure the same as the crystal structure of the third metal layer 23. Therefore, a metal of the third metal layer 23 would be easily diffused into the first metal layer 21. This would cause the light reflectance of the first metal layer 21 to be easily decreased. In view of the above, in the present disclosure, the second metal layer 22 having a crystal structure different from the crystal structure of the first metal layer 21 and the crystal structure of the third metal layer 23 is disposed between the first metal layer 21 and the third metal layer 23. With this configuration, interdiffusion of metals between the first metal layer 21 and the third metal layer 23 can be reduced.

### (Comparative Structure)

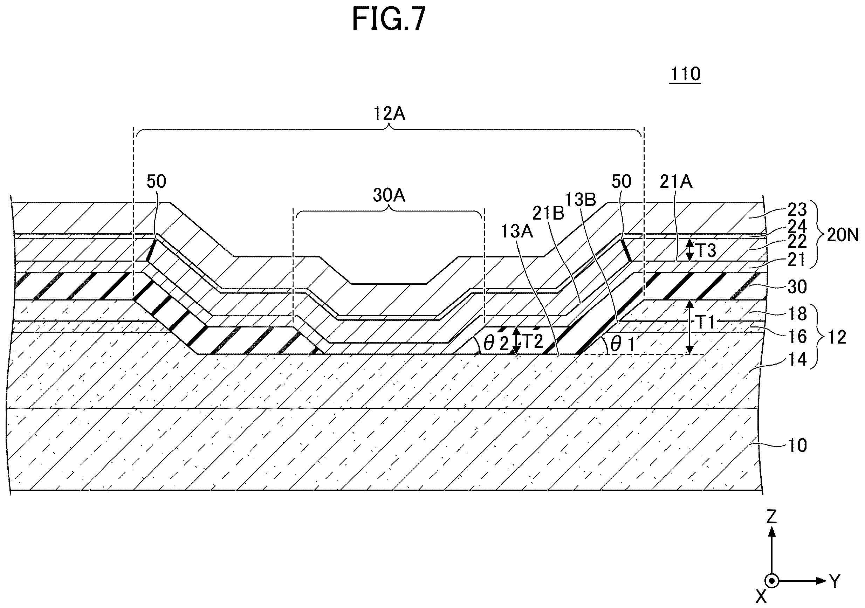

FIG. 7 is an enlarged cross-sectional view of a first opening 12A and a second opening 30A in a comparative structure. As illustrated in FIG. 7, in a light-emitting element 110 having the comparative structure, a third metal layer 23 is provided on a fourth metal layer 24 in the first opening 12A. In a case where a layer for reducing interdiffusion, such as a second metal layer 22, is formed, a crack 50 is likely to occur at the corner of an outer peripheral portion of the first opening 12A. This is because, when the second metal layer 22 is formed, the second metal layer 22 is formed on an upper surface 21A of the first metal layer 21 in a direction orthogonal to the upper surface 21A and is formed on a lateral surface 21B of the first metal layer 21 in a direction orthogonal to the lateral surface 21B. Because the second metal layer 22 is formed in two directions at a portion at which the upper surface 21A and the lateral surface 21B contact each other, a gap is likely to be formed between the upper surface 21A and the lateral surface 21B, thereby causing the crack 51. In particular, when the second metal layer 22 is formed by using a sputtering method, the crack 50 is likely to occur. If the crack 50 is formed, interdiffusion would occur between the first metal layer 21 and the third metal layer 23 via the crack 50. Further, there is a possibility that a similar crack occurs in the peripheral edge of the second opening 30A.

### (Description of First Embodiment)

In light of the above, according to the first embodiment, as illustrated in FIG. 5 and FIG. 6, the third metal layer 23 does not overlap the first opening 12A in a plan view. With this configuration, even when a crack 50 occurs in the third metal layer 23, interdiffusion between the first metal layer 21 and the third metal layer 23 can be reduced. Accordingly, a decrease in light reflectance of the first metal layer 21 can be reduced.

In order to increase the light reflectance of the first metal layer 21, the first metal layer 21 contains at least one of Al or Ag as a main component. As an example, the first metal layer 21 has an Al composition of 98 atomic % and contains Si and Cu. Table 1 indicates crystal structures and melting points of examples of metals that can be used for the first metal layer 21.

**[Table 1]**

| METAL | Al | Ag |
|---|---|---|
| CRYSTAL STRUCTURE | fcc | fcc |
| MELTING POINT [°C] | 660 | 961 |

In Table 1, fcc represents a face-centered cubic structure, hcp represents a hexagonal close-packed structure, and bcc represents a body-centered cubic structure.

The third metal layer 23 contains a metal having a low resistivity as a main component, and contains, for example, at least one of Au or Cu as a main component. As an example, the third metal layer 23 contains Au as a main component. For example, the light reflectances of Al, Ag, Au, and Cu are 80% or more, 90% or more, 70% or more, and 60% or more, respectively, with respect to light having a wavelength of 400 nm or more and 500 nm or less.

Table 2 indicates crystal structures and melting points of examples of metals that can be used for the third metal layer 23.

**[Table 2]**

| METAL | Au | Cu |
|---|---|---|
| CRYSTAL STRUCTURE | fcc | fcc |
| MELTING POINT [°C] | 1064 | 1084 |

As indicated in Table 1 and Table 2, the crystal structures of Al, Ag, Au, and Cu are fcc. That is, the crystal structure of the first metal layer 21 and the crystal structure of the third metal layer 23 are the same. Thus, interdiffusion easily occurs between the first metal layer 21 and the third metal layer 23. Therefore, a metal having a crystal structure different from fcc is used for the second metal layer 22. The second metal layer 22 contains, for example, at least one of titanium (Ti), tantalum (Ta), tungsten (W), molybdenum (Mo), niobium (Nb), chromium (Cr), zirconium (Zr), hafnium (Hf), or rhenium (Re) as a main component.

Table 3 indicates crystal structures and melting points of examples of metals that can be used for the second metal layer 22.

**[Table 3]**

| METAL | Ti | Ta | W | Mo | Nb | Cr | Zr | Hf |
|---|---|---|---|---|---|---|---|---|
| CRYSTAL STRUCTURE | hcp | bcc | bcc | bcc | bcc | bcc | hcp | hcp |
| MELTING POINT [°C] | 1668 | 3017 | 3380 | 2623 | 2468 | 1907 | 1855 | 2233 |

As indicated in Table 3, the crystal structures of Ti, Zr, Hf, and Re are hcp. The crystal structures of Ta, W, Mo, Nb, and Cr are bcc. That is, the crystal structures of Ti, Ta, W, Mo, Nb, Cr, Zr, Hf, and Re are different from the crystal structures of Al, Ag, Au, and Cu. In order to reduce interdiffusion between the first metal layer 21 and the third metal layer 23, the second metal layer 22 preferably has a dense crystal structure. From this viewpoint, the crystal structure of the second metal layer 22 is preferably a hexagonal close-packed structure.

To enhance the function of the second metal layer 22 to reduce interdiffusion between the first metal layer 21 and the third metal layer 23, the melting point of the second metal layer 22 is preferably higher than the melting point of the first metal layer 21 and the melting point of the third metal layer 23. As illustrated in Table 1 to Table 3, the melting point of the second metal layer 22 is higher than the melting point of the first metal layer 21 and the melting point of the third metal layer 23. For example, the melting point of the second metal layer 22 is preferably higher than the melting point of the first metal layer 21 and the melting point of the third metal layer 23 by 500°C or more. However, if a metal layer having a high melting point is formed, the metal layer is likely to have a columnar structure, and a crack is likely to occur. Therefore, it is preferable to dispose the third metal layer 23 so as not to overlap the first opening 12A.

If metals having a large difference in open circuit potential come into contact with each other, corrosion of the metals is likely to occur. For example, if the difference between the open circuit potential of the second metal layer 22 and the open circuit potential of the third metal layer 23 is large, corrosion of the second metal layer 22 and the third metal layer 23 easily occurs. Therefore, the fourth metal layer 24 having an open circuit potential between the open circuit potential of the second metal layer 22 and the open circuit potential of the third metal layer 23 is preferably disposed between the second metal layer 22 and the third metal layer 23. With this configuration, the difference between the open circuit potential of the second metal layer 22 and the open circuit potential of the fourth metal layer 24, and the difference between the open circuit potential of the fourth metal layer 24 and the open circuit potential of the third metal layer 23 can be made smaller than the difference between the open circuit potential of the second metal layer 22 and the open circuit potential of the third metal layer 23. Accordingly, corrosion of the second metal layer 22 and the third metal layer 23 can be reduced.

The fourth metal layer 24 contains, for example, at least one of Pt, ruthenium (Ru), or rhodium (Rh) as a main component. For example, the open circuit potential of Pt is between the open circuit potential of Au and the open circuit potential of Al. The order of open circuit potentials of metal elements is the same as the order of ionization tendency and the order of standard electrode potentials of the metal elements.

Table 4 indicates crystal structures and melting points of examples of metals that can be used for the fourth metal layer 24.

**[Table 4]**

| METAL | Pt | Ru | Rh |
|---|---|---|---|
| CRYSTAL STRUCTURE | fcc | hop | fcc |
| MELTING POINT [°C] | 1768 | 2334 | 1964 |

A metal layer containing a metal element as a main component allows the metal layer to contain another element to the extent that the metal layer maintains its functionality. For example, the concentration of the metal element in the metal layer is 70 atomic % or more, and preferably 85 atomic % or more.

In a case where the inclination angle θ1 is large and the thickness T3 of the second metal layer 22 is small, the crack 50 is likely to occur. Therefore, in the case of the inclination angle θ1 being 30° or more and the thickness T3 being less than the distance T1, it is preferable that the third metal layer 23 is provided so as not to overlap the first opening 12A in a plan view. In a case where the inclination angle θ1 is 40° or more, the crack 50 is more likely to occur, and in a case where the inclination angle θ1 is 45° or more, the crack 50 is even more likely to occur. Therefore, in these cases, it is preferable that the third metal layer 23 is provided so as not to overlap the first opening 12A in a plan view. If the inclination angle θ1 is too large, the n-side wiring 20N would be readily disconnected. From this viewpoint, the inclination angle θ1 is preferably 90° or less, more preferably 80° or less, and even more preferably 50° or less.

In a case where the thickness T3 is 0.8 times or less the distance T1, the crack 50 is likely to occur, and in a case where the thickness T3 is 0.5 times or less the distance T1, the crack 50 is more likely to occur. Therefore, in these cases, it is preferable that the third metal layer 23 is provided so as not to overlap the first opening 12A in a plan view. From the viewpoint of enhancing the function of the second metal layer 22 to reduce interdiffusion, the thickness T3 is preferably 0.1 times or more the distance T1, and more preferably 0.2 times or more the distance T1. The distance T1 is, for example, 500 nm or more and 3,000 nm or less, and is preferably 1,000 nm or more and 2,000 nm or less. The thickness T3 is, for example, 100 nm or more and 1,000 nm or less, and is preferably 200 nm or more and 500 nm or less.

In a case where the thickness T2 of the first insulating film 30 is less than the thickness T3 of the second metal layer 22, a crack is less likely to occur in the second metal layer 22 in the vicinity of the upper end 54 of the lateral surface of the first insulating film 30 defining the second opening 30A. In a case where the thickness T2 is greater than the thickness T3 and the inclination angle θ2 is 30° or more, a crack is likely to occur in the second metal layer 22 in the vicinity of the upper end 54 of the lateral surface of the first insulating film 30 defining the second opening 30A. In this case as well, a decrease in the light reflectivity of the n-side wiring 20N can be reduced by providing the third metal layer 23 so as not to overlap the first opening 12A in a plan view.

If the distance L1 from the first opening 12A to the third metal layer 23 is small, the first metal layer 21 and the third metal layer 23 would interdiffuse through the crack 50. From this viewpoint, the distance L1 is preferably 2 µm or more, and more preferably 5 µm or more. If the distance L1 is too large, the area in which the third metal layer 23 is disposed would be small and the resistance of the n-side wiring 20N would be increased. From this viewpoint, the distance L1 is preferably 20 µm or less, and more preferably 10 µm or less.

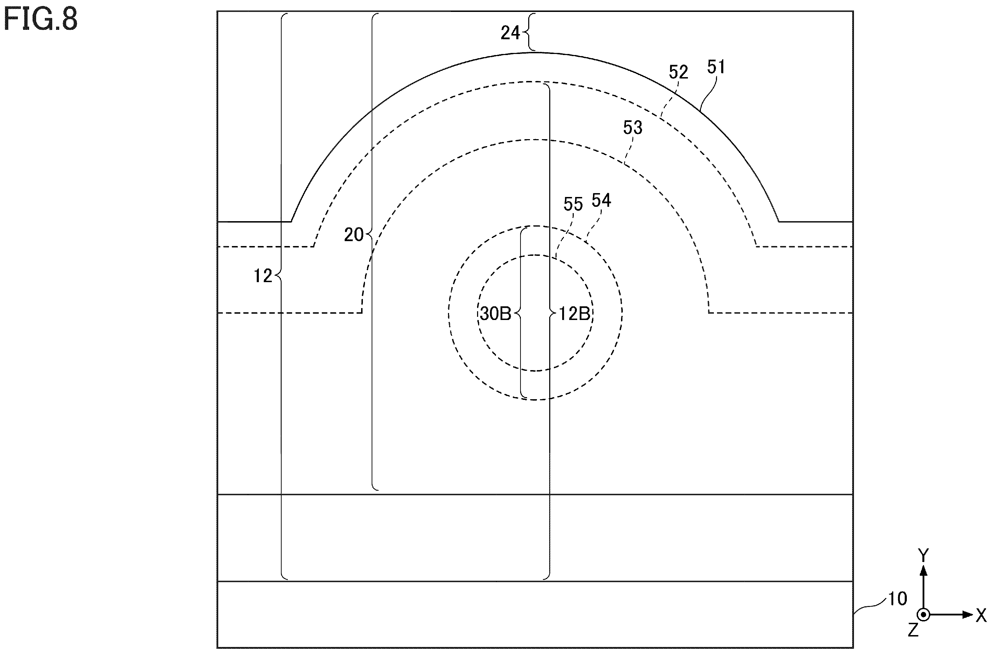

FIG. 8 is an enlarged plan view of the outer peripheral region 12B and the fourth opening 30B according to the first embodiment. In the present embodiment, as illustrated in FIG. 8, the third metal layer 23 of the n-side wiring 20N does not overlap the outer peripheral region 12B in a plan view. In this manner, as described above, a decrease in the reflectivity of the n-side wiring 20N can be reduced.

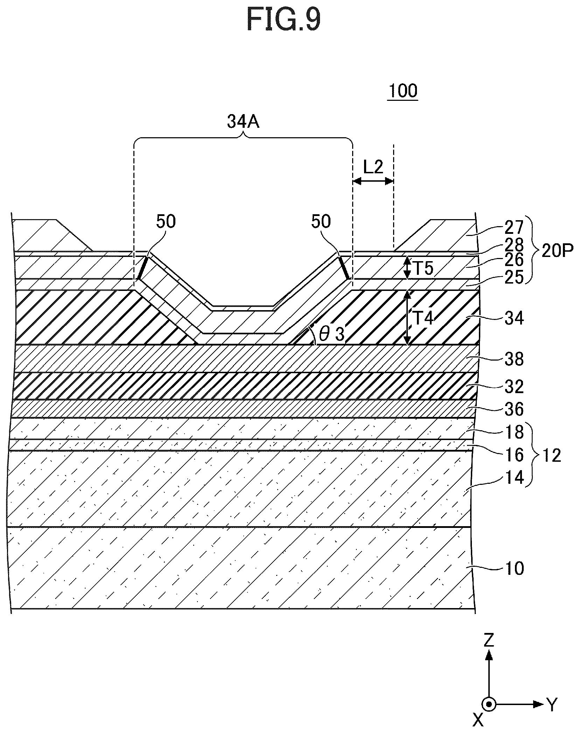

FIG. 9 is an enlarged cross-sectional view of the third opening 34A according to the first embodiment. In the present embodiment, as illustrated in FIG. 9, the second conductor layer 38 is disposed over the semiconductor structure 12 and is electrically connected to the p-side semiconductor layer 18 via the first conductor layer 36 (see FIG. 4). The second insulating film 34 is disposed on the second conductor layer 38 and has the third opening 34A exposing the second conductor layer 38. In the present embodiment, the second insulating film and the second layer are formed in the same process and thus are denoted by the same reference numeral. The p-side wiring 20P contacts the second conductor layer 38 in the third opening 34A, and includes a fifth metal layer 25, a sixth metal layer 26, and a seventh metal layer 27. An eighth metal layer 28 may be disposed between the sixth metal layer 26 and the seventh metal layer 27. The seventh metal layer 27 does not overlap the third opening 34A in a plan view. The fifth metal layer 25 is formed of the same material as the material of the first metal layer 21. The sixth metal layer 26 is formed of the same material as the material of the second metal layer 22. The seventh metal layer 27 is formed of the same material as the material of the third metal layer 23. The eighth metal layer 28 is formed of the same material as the material of the fourth metal layer 24. Accordingly, the p-side wiring 20P can obtain the same effects as those of the n-side wiring 20N.

The thickness of the second insulating film 34 is defined as T4, and the inclination angle of a lateral surface of the second layer 34 relative to the surface of the second conductor layer 38 is defined as θ3. In a case where the inclination angle θ3 is large and a thickness T5 of the sixth metal layer 26 is small, a crack 50 is likely to occur. Therefore, in a case where the inclination angle θ3 is 30° or more and the thickness T5 is less than the thickness T4, it is preferable that the seventh metal layer 27 is provided so as not to overlap the third opening 34A. A distance L2 from the third opening 34A to the seventh metal layer 27 is preferably 2 µm or more.

The first metal layer 21 contains a metal element selected from at least one of Al or Ag. The content ratio of the metal element selected from the at least one of Al or Ag is preferably the highest in the first metal layer 21. For example, the content ratio of the metal element selected from the at least one of Al or Ag is preferably 95 atomic % or more, and more preferably 98 atomic % or more in the first metal layer 21. The second metal layer 22 contains a metal element selected from at least one of Ti, Ta, W, Mo, Nb, Cr, Zr, Hf, or Re. The content ratio of the metal element selected from the at least one of Ti, Ta, W, Mo, Nb, Cr, Zr, Hf, or Re is preferably the highest in the second metal layer 22. For example, the content ratio of the metal element selected from the at least one of Ti, Ta, W, Mo, Nb, Cr, Zr, Hf, or Re is preferably 95 atomic % or more, and more preferably 98 atomic % or more in the second metal layer 22. The third metal layer 23 contains a metal element selected from at least one of Au or Cu. The content ratio of the metal element selected from the at least one of Au or Cu is preferably the highest in the third metal layer 23. For example, the content ratio of the metal element selected from the at least one of Au or Cu is preferably 95 atomic % or more, and more preferably 98 atomic % or more in the third metal layer 23. The fourth metal layer 24 contains a metal element selected from at least one of Pt, Ru, or Rh. The content ratio of the metal element selected from the at least one of Pt, Ru, or Rh is preferably the highest in the fourth metal layer 24. For example, the content ratio of the metal element selected from the at least one of Pt, Ru, or Rh is preferably 95 atomic % or more, and more preferably 98 atomic % or more in the fourth metal layer 24. The content ratio of a certain metal element to metal element(s) contained in a metal layer is the ratio of the concentration of the certain metal element in the metal layer to the total concentration of detectable metal elements contained in the metal layer, which is represented by atomic %. The first metal layer 21, the second metal layer 22, the third metal layer 23, and the fourth metal layer 24 may contain elements (for example, oxygen (O), nitrogen (N), and carbon (C)) other than metal elements.

Although embodiments have been described in detail above, the above-described embodiments are nonlimiting examples, and various modifications and substitutions can be made to the above-described embodiments without departing from the scope of the claims.

According to an embodiment of the present disclosure, a decrease in light reflectance of wiring of a light-emitting element can be reduced.

### DESCRIPTION OF THE REFERENCE NUMERALS

10: substrate
12: semiconductor structure
12A: first opening
12B: outer peripheral region
13A: first surface
13B: second surface
14: n-side semiconductor layer
16: active layer
18: p-side semiconductor layer
20: wiring
20B: opening
20C: protruding portion
20N: n-side wiring
20P: p-side wiring
21: first metal layer
22: second metal layer
23: third metal layer
24: fourth metal layer
25: fifth metal layer
26: sixth metal layer
27: seventh metal layer
28: eighth metal layer
29N: n-side electrode
29P: p-side electrode
30: first insulating film
30A: second opening
30B: fourth opening
32: first layer
34: second layer
34A: third opening
36: first conductor layer
38: second conductor layer

## Claims

1. A light-emitting element comprising:
a semiconductor structure comprising:
an n-side semiconductor layer,
an active layer disposed on the n-side semiconductor layer, and
a p-side semiconductor layer disposed on the active layer, wherein:
a first opening extends through the active layer and the p-side semiconductor layer, and
the n-side semiconductor layer is exposed from the active layer and the p-side semiconductor layer by the first opening;
a first insulating film disposed on the semiconductor structure, wherein a second opening extends through the first insulating film at a position overlapping the first opening in a plan view; and
n-side wiring comprising:
a first metal layer contacting the n-side semiconductor layer via the second opening,
a second metal layer disposed on the first metal layer, and
a third metal layer disposed on the second metal layer; wherein:
a light reflectance of the first metal layer with respect to a peak wavelength of light emitted from the active layer is higher than a light reflectance of the third metal layer with respect to the peak wavelength of the light emitted from the active layer;
a crystal structure of the first metal layer is the same as a crystal structure of the third metal layer;
a crystal structure of the second metal layer is different from the crystal structure of the first metal layer and the crystal structure of the third metal layer; and
the third metal layer does not overlap the first opening in the plan view.

2. The light-emitting element according to claim 1, wherein a melting point of the second metal layer is higher than a melting point of the first metal layer and a melting point of the third metal layer.

3. The light-emitting element according to claim 1 or 2, wherein the crystal structure of the second metal layer is a hexagonal close-packed structure.

4. The light-emitting element according to claim any one of claims 1 to 3, wherein the second metal layer contains, as a main component, at least one of Ti, Ta, W, Mo, Nb, Cr, Zr, Hf, or Re.

5. The light-emitting element according to any one of claims 1 to 4, wherein the first metal layer contains, as a main component, at least one of Al or Ag.

6. The light-emitting element according to any one of claims 1 to 5, wherein the third metal layer contains, as a main component, at least one of Au or Cu.

7. The light-emitting element according to any one of claims 1 to 6, wherein:
the semiconductor structure has a first surface and a second surface defining the first opening;
the first surface is defined by a portion of a surface of the n-side semiconductor layer;
the second surface is defined by a portion of a lateral surface of the n-side semiconductor layer, a portion of a lateral surface of the active layer, and a portion of a lateral surface of the p-side semiconductor layer, and meets the first surface;
an inclination angle of the second surface relative to the first surface is 30° or more; and
a thickness of the second metal layer is less than a distance between the first surface and a surface of the p-side semiconductor layer.

8. The light-emitting element according to any one of claims 1 to 7, wherein, in the plan view, the third metal layer is separated from the first opening by 2 µm or more.

9. The light-emitting element according to any one of claims 1 to 8, wherein:
the n-side wiring comprises a fourth metal layer disposed between the second metal layer and the third metal layer; and
an open circuit potential of the fourth metal layer is between an open circuit potential of the second metal layer and an open circuit potential of the third metal layer.

10. The light-emitting element according to any one of claims 1 to 8, wherein:
the n-side wiring comprises a fourth metal layer disposed between the second metal layer and the third metal layer; and
the fourth metal layer contains, as a main component, at least one of Pt, Ru, or Rh.

11. The light-emitting element according to any one of claims 1 to 10, further comprising:
a conductor layer disposed on the semiconductor structure and electrically connected to the p-side semiconductor layer;
a second insulating film disposed on the conductor layer, wherein a third opening extends through the second insulating film, and the conductor layer is exposed from the second insulating film by the third opening; and
p-side wiring contacting the conductor layer in the third opening and comprising:
a fifth metal layer,
a sixth metal layer disposed on the fifth metal layer, and
a seventh metal layer disposed on the sixth metal layer; wherein:
a light reflectance of the fifth metal layer with respect to the peak wavelength of the light emitted from the active layer is higher than a light reflectance of the seventh metal layer with respect to the peak wavelength of the light emitted from the active layer;
a crystal structure of the fifth metal layer is the same as a crystal structure of the seventh metal layer;
a crystal structure of the sixth metal layer is different from the crystal structure of the fifth metal layer and the crystal structure of the seventh metal layer; and
the seventh metal layer does not overlap the third opening in the plan view.

12. A light-emitting element comprising:
a semiconductor structure comprising:
an n-side semiconductor layer,
an active layer disposed on the n-side semiconductor layer, and
a p-side semiconductor layer disposed on the active layer, wherein:
a first opening extends through the active layer and the p-side semiconductor, and
the n-side semiconductor layer is exposed from the active layer and the p-side semiconductor layer by the first opening;
a first insulating film disposed on the semiconductor structure, wherein a second opening extends through the first insulating film at a position overlapping the first opening in a plan view; and
n-side wiring comprising:
a first metal layer contacting the n-side semiconductor layer via the second opening,
a second metal layer disposed on the first metal layer, and
a third metal layer disposed on the second metal layer; wherein:
the first metal layer contains a metal element selected from at least one of Al or Ag;
the second metal layer contains a metal element selected from at least one of Ti, Ta, W, Mo, Nb, Cr, Zr, Hf, or Re;
the third metal layer contains a metal element selected from at least one of Au or Cu; and
the third metal layer does not overlap the first opening in the plan view.

13. The light-emitting element according to claim 12, wherein:
a content ratio of the metal element selected from the at least one of Al or Ag in the first metal layer is higher than a content ratio of any other element in the first metal layer;
a content ratio of the metal element selected from the at least one of Ti, Ta, W, Mo, Nb, Cr, Zr, Hf, or Re in the second metal layer is higher than a content ratio of any other element in the second metal layer; and
a content ratio of the metal element selected from the at least one of Au or Cu in the third metal layer is higher than a content ratio of any other element in the third metal layer.

14. The light-emitting element according to claim 12 or 13, wherein:
a content ratio of the metal element selected from the at least one of Al or Ag is 95 atomic % or more in the first metal layer;
a content ratio of the metal element selected from the at least one of Ti, Ta, W, Mo, Nb, Cr, Zr, Hf, or Re is 95 atomic % or more in the second metal layer; and
a content ratio of the metal element selected from the at least one of Au or Cu is 95 atomic % or more in the third metal layer.

15. The light-emitting element according to any one of claims 12 to 14, wherein:
a crystal structure of the first metal layer is the same as a crystal structure of the third metal layer; and
a crystal structure of the second metal layer is different from the crystal structure of the first metal layer and the crystal structure of the third metal layer.

16. The light-emitting element according to any one of claims 12 to 15, wherein a light reflectance of the first metal layer with respect to a peak wavelength of light emitted from the active layer is higher than a light reflectance of the third metal layer with respect to the peak wavelength of the light emitted from the active layer.

17. The light-emitting element according to claim any one of claims 12 to 16, wherein:
the n-side wiring comprises a fourth metal layer disposed between the second metal layer and the third metal layer; and
the fourth metal layer contains a metal element selected from at least one of Pt, Ru, or Rh.

18. The light-emitting element according to claim 17, wherein a content ratio of the metal element selected from the at least one of Pt, Ru, or Rh in the fourth metal layer is higher than a content ratio of any other element in the fourth metal layer .

19. The light-emitting element according to claim 17 or 18, wherein a content ratio of the metal element selected from the at least one of Pt, Ru, or Rh is 95 atomic % or more in the fourth metal layer.

20. The light-emitting element according to any one of claims 12 to 19, wherein:
the n-side wiring comprises a fourth metal layer disposed between the second metal layer and the third metal layer, and
an open circuit potential of the fourth metal layer is between an open circuit potential of the second metal layer and an open circuit potential of the third metal layer.
